(19) Europäisches Patentamt
European Patent Office
Office européen des brevets

(11) EP 3 888 836 A1

(12) **EUROPEAN PATENT APPLICATION**
published in accordance with Art. 153(4) EPC

(43) Date of publication:
06.10.2021 Bulletin 2021/40

(51) Int Cl.:
*B23K 20/00* (2006.01)    *C22C 21/00* (2006.01)
*H01L 23/36* (2006.01)    *H01L 23/40* (2006.01)

(21) Application number: 19890256.1

(22) Date of filing: 27.11.2019

(86) International application number:
PCT/JP2019/046332

(87) International publication number:
WO 2020/111107 (04.06.2020 Gazette 2020/23)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 28.11.2018 JP 2018222347

(71) Applicant: Mitsubishi Materials Corporation
Tokyo 100-8117 (JP)

(72) Inventor: TERASAKI Nobuyuki
Saitama-shi, Saitama 330-8508 (JP)

(74) Representative: Hoffmann Eitle
Patent- und Rechtsanwälte PartmbB
Arabellastraße 30
81925 München (DE)

(54) **BONDED BODY, HEAT SINK-ATTACHED INSULATED CIRCUIT BOARD, AND HEAT SINK**

(57)    A bonded body includes a copper member (13B) and an aluminum alloy member (31), the copper member (13B) and the aluminum alloy member (31) being bonded to each other, in which, in the aluminum alloy member (31), a Si concentration is in a range of 1.5 mass% or more and 12.5 mass% or less, an Fe concentration is 0.15 mass% or less, a Cu concentration is 0.05 mass% or less, the aluminum alloy member (31) and the copper member (13B) are bonded to each other by solid phase diffusion bonding, and a ratio t2/t1 of a thickness t2 of a second intermetallic compound layer (42) that is positioned on the copper member (13B) side and is made of a non-θ phase other than the θ phase to a thickness t1 of a first intermetallic compound layer (41) that is positioned on the aluminum alloy member (31) side and is made of a θ phase is in a range of 1.2 or more and 2.0 or less.

FIG. 1

EP 3 888 836 A1

Printed by Jouve, 75001 PARIS (FR)

**Description**

TECHNICAL FIELD

This invention relates to a bonded body in which an aluminum alloy member made of an aluminum alloy and a copper member made of copper or a copper alloy are bonded to each other, an insulating circuit substrate with a heat sink in which the heat sink is bonded to the insulating circuit substrate having a circuit layer formed on one surface of an insulating layer, and a heat sink in which a copper member layer is formed on a heat sink main body.

Priority is claimed on Japanese Patent Application No. 2018-222347, filed November 28, 2018, the content of which is incorporated herein by reference.

BACKGROUND ART

Semiconductor devices such as LEDs or power modules have a structure in which a semiconductor element is bonded onto a circuit layer made of a conductive material.

In power semiconductor elements for high-power control that are used to control wind-power generation, electric vehicles, hybrid vehicles, and the like, since the amount of heat generated is large, as a substrate on which the power semiconductor element is mounted, for example, an insulating circuit substrate including a ceramic substrate made of aluminum nitride (AlN), alumina ($Al_2O_3$), or the like and a circuit layer formed by bonding a metal plate having an excellent conductive property to one surface of the ceramic substrate has been broadly used in the related art. As a power module substrate, substrates having a metal layer formed on the other surface of the ceramic substrate also have been provided.

For example, a power module described in Patent Document 1 is provided with a structure in which an insulating circuit substrate having a circuit layer and a metal layer made of aluminum or an aluminum alloy provided on one surface and the other surface of a ceramic substrate, respectively, and a semiconductor element bonded onto the circuit layer through a solder material are provided.

In addition, the power module is provided with a configuration in which a heat sink is bonded to the metal layer side of the insulating circuit substrate and heat transferred from the semiconductor element toward the insulating circuit substrate side is dissipated to the outside through the heat sink.

By the way, in a case where the circuit layer and the metal layer are made of aluminum or an aluminum alloy as in the power module described in Patent Document 1, since an Al oxide film is formed on the surface, there is a problem in that it is not possible to bond the semiconductor element or the heat sink with the solder material.

Therefore, Patent Document 2 proposes an insulating circuit substrate in which a circuit layer and a metal layer have a laminate structure of an Al layer and a Cu layer. In this insulating circuit substrate, since the Cu layer is disposed on the surface of each of the circuit layer and the metal layer, it is possible to favorably bond a semiconductor element and a heat sink using a solder material. Therefore, heat resistance in the lamination direction becomes small, and it becomes possible to efficiently transfer heat generated from the semiconductor element toward the heat sink side.

As described in Patent Document 2, an insulating circuit substrate having a structure in which a heat radiation plate is used as a heat sink and this heat radiation plate is screwed to a cooling portion with a fastening screw is also proposed.

In addition, Patent Document 3 proposes an insulating circuit substrate with a heat sink in which one of a metal layer and a heat sink is made of aluminum or an aluminum alloy, the other is made of copper or a copper alloy, and the metal layer and the heat sink are bonded to each other by solid phase diffusion bonding. In this insulating circuit substrate with a heat sink, since the metal layer and the heat sink are bonded to each other by solid phase diffusion bonding, the heat resistance is small, and the heat radiation characteristic is excellent.

Furthermore, Patent Document 4 proposes an insulating circuit substrate with a heat sink in which a heat sink made of an aluminum alloy containing a relatively large amount of Si such as ADC12 and a metal layer made of copper are bonded to each other by solid phase diffusion bonding. In addition, a heat sink in which a heat sink main body made of an aluminum alloy containing a relatively large amount of Si such as ADC12 and a metal member layer made of copper are bonded to each other by solid phase diffusion bonding is also proposed.

Since the aluminum alloy containing a relatively large amount of Si such as ADC12 has a high strength and a low melting point, it is possible to form a variety of shapes and to configure a heat sink having an excellent heat radiation characteristic.

Citation List

Patent Literature

[Patent Document 1]
Japanese Patent No. 3171234
[Patent Document 2]
Japanese Unexamined Patent Application, First Publication No. 2014-160799
[Patent Document 3]
Japanese Unexamined Patent Application, First Publication No. 2014-099596
[Patent Document 4]
Japanese Unexamined Patent Application, First Publication No. 2016-208010

SUMMARY OF INVENTION

Technical Problem

Meanwhile, since the aluminum alloy such as ADC12 contains many added elements, thermal conductivity tends to decrease. Therefore, in the case of mounting a semiconductor element or the like from which a large amount of heat is generated, there has been a concern that the heat radiation characteristic may become insufficient.

In contrast, pure aluminum has a high thermal conductivity and an excellent heat radiation characteristic. However, pure aluminum significantly softens at a high temperature, and thus it is difficult to fasten pure aluminum with a screw. In addition, due to a relatively large linear thermal expansion coefficient, pure aluminum significantly warps, and there is a concern that pure aluminum may not sufficiently bond to other members.

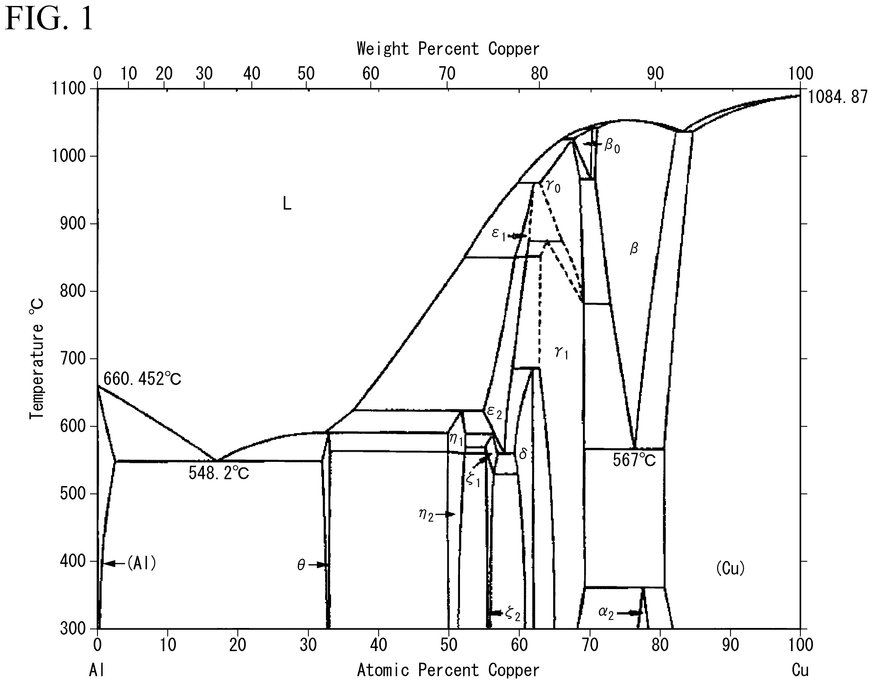

In addition, in a case where an aluminum alloy member made of aluminum alloy and a copper member made of copper or a copper alloy are bonded to each other by solid phase diffusion bonding as described in Patent Document 3 and 4, an intermetallic compound layer made up of copper and aluminum is formed in a bonding interface between the aluminum alloy member and the copper member. Here, as an intermetallic compound made up of copper and aluminum, there is a plurality of phases as shown in Fig. 1. Therefore, in the intermetallic compound layer formed in the bonding interface between the aluminum alloy member and the copper member, individual phases of a $\theta$ phase, an $\eta_2$ phase, a $\zeta_2$ phase, a $\delta$ phase, and a $\gamma_2$ phase are formed.

Here, since the above-described intermetallic compound layer is relatively hard and brittle, when the intermetallic compound layer is subjected to a thermal cycle, there is a concern that a breaking may be generated and a bonding rate may decrease.

The present invention has been made in consideration of the above-described circumstances, and an object of the present invention is to provide a bonded body that includes an aluminum alloy member made of an aluminum alloy and a copper member made of copper or a copper alloy, the aluminum alloy member and the copper member being bonded to each other by solid phase diffusion bonding, has excellent thermal cycle reliability, and is excellent in terms of the heat radiation characteristic and the strength, an insulating circuit substrate with a heat sink and a heat sink both including the bonded body.

Solution to Problem

In order to solve the above-described problem, a bonded body of the present invention is a bonded body having a copper member made of copper or a copper alloy and an aluminum alloy member made of an aluminum alloy containing Si, the copper member and the aluminum alloy member being bonded to each other, in which the aluminum alloy has a Si concentration being in a range of 1.5 mass% or more and 12.5 mass% or less, an Fe concentration being 0.15 mass% or less, and a Cu concentration being 0.05 mass% or less, the aluminum alloy member and the copper member are bonded to each other by solid phase diffusion bonding, an intermetallic compound layer made of an intermetallic compound containing Cu and Al is provided in a bonding interface between the aluminum alloy member and the copper member, in the intermetallic compound layer, a first intermetallic compound layer that is positioned on the aluminum alloy member side and is made of a $\theta$ phase and a second intermetallic compound layer that is positioned on the copper member side and is made of a non-$\theta$ phase other than the $\theta$ phase are laminated, and a ratio t2/t1 of a thickness t2 of the second intermetallic compound layer made of the non-$\theta$ phase to a thickness t1 of the first intermetallic compound layer made of the $\theta$ phase is in a range of 1.2 or more and 2.0 or less.

According to the bonded body having this configuration, since the aluminum alloy has a Si concentration set in a range of 1.5 mass% or more and 12.5 mass% or less, an Fe concentration set to 0.15 mass% or less, and a Cu concentration set to 0.05 mass% or less, the strength of the aluminum alloy member is high, and the thermal conductivity becomes relatively high. Therefore, it is possible to efficiently transfer heat spread in the copper member toward the aluminum alloy member.

In addition, in the present invention, since the aluminum alloy that configures the aluminum alloy member has a Si concentration set in a range of 1.5 mass% or more and 12.5 mass% or less, an Fe concentration set to 0.15 mass% or less, and a Cu concentration set to 0.05 mass% or less, and, in the intermetallic compound layer formed in the bonding interface between the aluminum alloy member and the copper member, the ratio t2/t1 of the thickness t2 of the second intermetallic compound layer that is positioned on the copper member side and is made of the non-θ phase other than the θ phase to the thickness t1 of the first intermetallic compound layer that is positioned on the aluminum alloy member side and is made of the θ phase is set to 1.2 or more, the thickness of the first intermetallic compound layer made of the θ phase is not thicker than necessary, and the generation of a breaking attributed to the θ phase can be suppressed. In addition, since the thickness of the second intermetallic compound layer that is positioned on the copper member side and is made of the non-θ phase is secured, the deformation resistance of the copper member becomes high, even in a case where an external force is applied due to fastening or the like, the copper member does not easily deform, and the generation of a breaking in the intermetallic compound layer can be suppressed.

Furthermore, since the ratio t2/t1 of the thickness t2 of the second intermetallic compound layer to the thickness t1 of the first intermetallic compound layer is set to 2.0 or less, the thickness of the first intermetallic compound layer that is positioned on the aluminum alloy member side and is made of the θ phase is secured. Therefore, the deformation resistance of the aluminum alloy member becomes high, even in a case where an external force is applied due to fastening or the like, the aluminum alloy member does not easily deform, and the generation of a breaking in the intermetallic compound layer can be suppressed.

An insulating circuit substrate with a heat sink of the present invention is an insulating circuit substrate with a heat sink including an insulating layer, a circuit layer formed on one surface of the insulating layer, a metal layer formed on the other surface of the insulating layer, and a heat sink disposed on a surface of the metal layer opposite to the insulating layer, in which a bonding surface of the metal layer with the heat sink is made of copper or a copper alloy, a bonding surface of the heat sink with the metal layer is made of an aluminum alloy having a Si concentration being in a range of 1.5 mass% or more and 12.5 mass% or less, an Fe concentration being 0.15 mass% or less, and a Cu concentration being 0.05 mass% or less, the heat sink and the metal layer are bonded to each other by solid phase diffusion bonding, an intermetallic compound layer made of an intermetallic compound containing Cu and Al is provided in a bonding interface between the heat sink and the metal layer, in the intermetallic compound layer, a first intermetallic compound layer that is positioned on the heat sink side and is made of a θ phase and a second intermetallic compound layer that is positioned on the metal layer side and is made of a non-θ phase other than the θ phase are laminated, and a ratio t2/t1 of a thickness t2 of the second intermetallic compound layer made of the non-θ phase to a thickness t1 of the first intermetallic compound layer made of the θ phase is in a range of 1.2 or more and 2.0 or less.

According to the insulating circuit substrate with a heat sink having this configuration, since the heat sink is made of an aluminum alloy having a Si concentration set in a range of 1.5 mass% or more and 12.5 mass% or less, an Fe concentration set to 0.15 mass% or less, and a Cu concentration set to 0.05 mass% or less, the strength of the heat sink is high, and it is possible to fasten the heat sink with a screw, to suppress the warpage of the heat sink, and to attach the heat sink to a cooler or the like. In addition, since the thermal conductivity of the heat sink becomes relatively high, the heat radiation characteristic is excellent.

In addition, in the intermetallic compound layer formed in the bonding interface between the heat sink and the metal layer, since the ratio t2/t1 of the thickness t2 of the second intermetallic compound layer that is positioned on the metal layer side and is made of the non-θ phase other than the θ phase to the thickness t1 of the first intermetallic compound layer that is positioned on the heat sink side and is made of the θ phase is set to 1.2 or more, the thickness of the first intermetallic compound layer made of the θ phase is not thicker than necessary, and the generation of a breaking attributed to the θ phase can be suppressed. In addition, since the thickness of the second intermetallic compound layer that is positioned on the metal layer side and is made of the non-θ phase is secured, the deformation resistance of the metal layer becomes high, even in a case where an external force is applied due to fastening or the like, the metal layer does not easily deform, and the generation of a breaking in the intermetallic compound layer can be suppressed.

Furthermore, since the ratio t2/t1 of the thickness t2 of the second intermetallic compound layer to the thickness t1 of the first intermetallic compound layer is set to 2.0 or less, the thickness of the first intermetallic compound layer that is positioned on the heat sink side and is made of the θ phase is secured. Therefore, the deformation resistance of the heat sink becomes high, even in a case where an external force is applied due to fastening or the like, the heat sink does not easily deform, and the generation of a breaking in the intermetallic compound layer can be suppressed.

A heat sink of the present invention is a heat sink including a heat sink main body and a copper member layer that is bonded to the heat sink main body and is made of copper or a copper alloy, in which the heat sink main body is made of an aluminum alloy having a Si concentration being in a range of 1.5 mass% or more and 12.5 mass% or less, an Fe concentration being 0.15 mass% or less, and a Cu concentration being 0.05 mass% or less, the heat sink main body and the copper member layer are bonded to each other by solid phase diffusion bonding, an intermetallic compound layer made of an intermetallic compound containing Cu and Al is provided in a bonding interface between the heat sink main body and the copper member layer, in the intermetallic compound layer, a first intermetallic compound layer that is positioned on the heat sink main body side and is made of a θ phase and a second intermetallic compound layer that is positioned on the copper member layer side and is made of a non-θ phase other than the θ phase are laminated, and a ratio t2/t1 of a thickness t2 of the second intermetallic compound layer made of the non-θ phase to a thickness t1 of the first intermetallic compound layer made of the θ phase is in a range of 1.2 or more and 2.0 or less.

According to the heat sink having this configuration, since the heat sink main body is made of an aluminum alloy having a Si concentration set in a range of 1.5 mass% or more and 12.5 mass% or less, an Fe concentration set to 0.15 mass% or less, and a Cu concentration set to 0.05 mass% or less, the strength of the heat sink main body is high, and it is possible to fasten the heat sink with a screw, to suppress the warpage of the heat sink, and to attach the heat sink to a cooler or the like. In addition, since the thermal conductivity of the heat sink main body becomes relatively high, the heat radiation characteristic is excellent.

In addition, in the intermetallic compound layer formed in the bonding interface between the heat sink main body and the copper member layer, since the ratio t2/t1 of the thickness t2 of the second intermetallic compound layer that is positioned on the copper member layer side and is made of the non-θ phase other than the θ phase to the thickness t1 of the first intermetallic compound layer that is positioned on the heat sink main body side and is made of the θ phase is set to 1.2 or more, the thickness of the first intermetallic compound layer made of the θ phase is not thicker than necessary, and the generation of a breaking attributed to the θ phase can be suppressed. In addition, since the thickness of the second intermetallic compound layer that is positioned on the copper member layer side and is made of the non-θ phase is secured, the deformation resistance of the copper member layer becomes high, even in a case where an external force is applied due to fastening or the like, the copper member layer does not easily deform, and the generation of a breaking in the intermetallic compound layer can be suppressed.

Furthermore, since the ratio t2/t1 of the thickness t2 of the second intermetallic compound layer to the thickness t1 of the first intermetallic compound layer is set to 2.0 or less, the thickness of the first intermetallic compound layer that is positioned on the heat sink main body side and is made of the θ phase is secured. Therefore, the deformation resistance of the heat sink main body becomes high, even in a case where an external force is applied due to fastening or the like, the heat sink main body does not easily deform, and the generation of a breaking in the intermetallic compound layer can be suppressed.

Advantageous Effects of Invention

According to the present invention, it becomes possible to provide a bonded body that includes an aluminum alloy member made of an aluminum alloy and a copper member made of copper or a copper alloy being bonded to each other by solid phase diffusion bonding, has excellent thermal cycle reliability, and is excellent in terms of the heat radiation characteristic and the strength, an insulating circuit substrate with a heat sink and a heat sink both including the bonded body.

BRIEF DESCRIPTION OF DRAWINGS

Fig. 1 is a binary phase diagram of Cu and Al.
Fig. 2 is a schematic explanatory view of a power module including an insulating circuit substrate with a heat sink according to a first embodiment of the present invention.
Fig. 3 is an enlarged cross-sectional explanatory view of a bonding interface between a heat sink and a metal layer (Cu layer) of the insulating circuit substrate with a heat sink shown in Fig. 2.
Fig. 4 is a flowchart showing a method for manufacturing the insulating circuit substrate with a heat sink according to the first embodiment.
Fig. 5 is a schematic explanatory view of the method for manufacturing the insulating circuit substrate with a heat sink according to the first embodiment.
Fig. 6 is a schematic explanatory view of a heat sink according to a second embodiment of the present invention.
Fig. 7 is an enlarged cross-sectional explanatory view of a bonding interface between a heat sink main body and a copper member layer in the heat sink shown in Fig. 6.
Fig. 8 is a flowchart showing a method for manufacturing the heat sink according to the second embodiment.
Fig. 9 is a schematic explanatory view of the method for manufacturing the heat sink according to the second embodiment.
Fig. 10 is a schematic explanatory view of a power module including an insulating circuit substrate with a heat sink that is another embodiment of the present invention.
Fig. 11 is a schematic explanatory view showing a status in which solid-phase diffusion bonding is performed by an electric heating method.

DESCRIPTION OF EMBODIMENTS

(First embodiment)

Hereinafter, embodiments of the present invention will be described with reference to accompanying drawings.

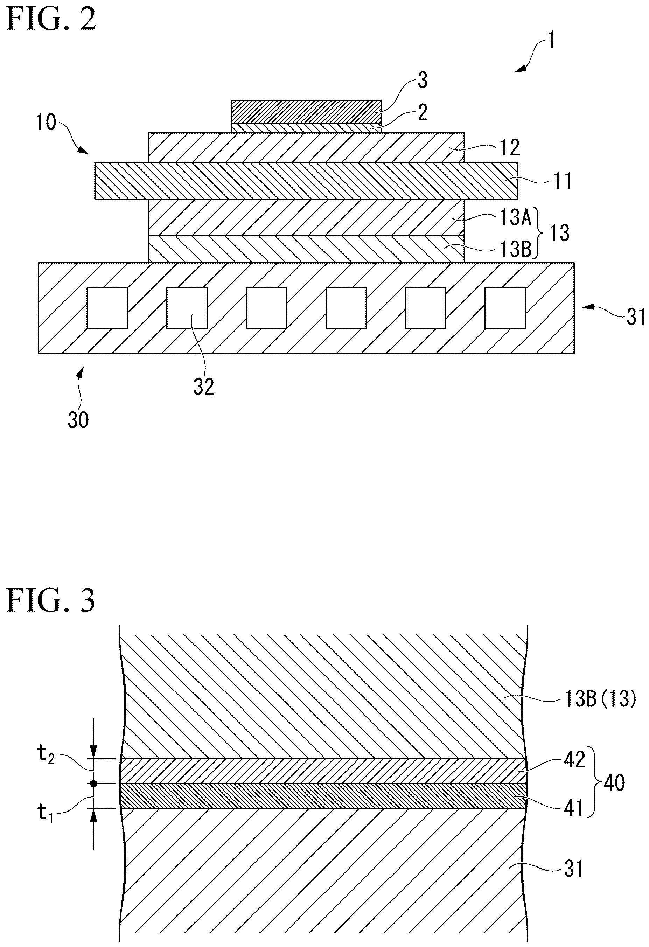

Fig. 2 shows a power module 1 in which an insulating circuit substrate with a heat sink 30, which is a first embodiment of the present invention, is used.

This power module 1 includes the insulating circuit substrate with a heat sink 30 and a semiconductor element 3 bonded to one surface (upper surface in Fig. 2) of the insulating circuit substrate with a heat sink 30 through a solder layer 2.

The insulating circuit substrate with a heat sink 30 includes an insulating circuit substrate 10 and a heat sink 31 bonded to the insulating circuit substrate 10.

The insulating circuit substrate 10 includes a ceramic substrate 11 that configures an insulating layer, a circuit layer 12 disposed on one surface (upper surface in Fig. 2) of the ceramic substrate 11, and a metal layer 13 disposed on the other surface of the ceramic substrate 11.

The ceramic substrate 11 is made of ceramic that is excellent in terms of an insulating property and a heat radiation such as silicon nitride ($Si_3N_4$), aluminum nitride (AlN), or alumina ($Al_2O_3$). In the present embodiment, the ceramic substrate 11 is made of aluminum nitride (AlN) that is particularly excellent in terms of the heat radiation. In addition, the thickness of the ceramic substrate 11 is set in a range of, for example, 0.2 to 1.5 mm and, in the present embodiment, set to 0.635 mm.

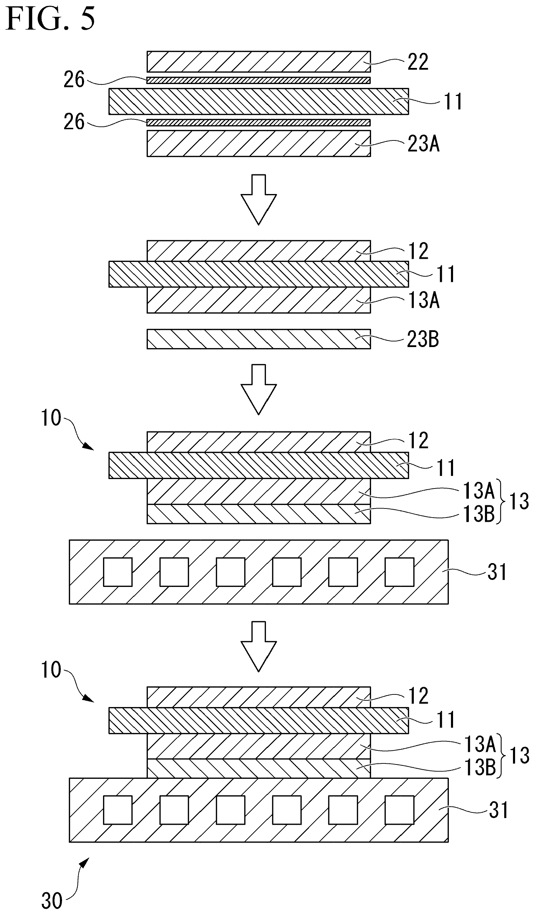

The circuit layer 12 is formed by bonding an aluminum plate 22 made of aluminum or an aluminum alloy to one surface of the ceramic substrate 11 as shown in Fig. 5. In the present embodiment, the circuit layer 12 is formed by bonding a rolled plate (aluminum plate 22) of aluminum having a purity of 99 mass% or higher (2N aluminum) or aluminum having a purity of 99.99 mass% or higher (4N aluminum) to the ceramic substrate 11. The thickness of the aluminum plate 22 that serves as the circuit layer 12 is set in a range of 0.1 mm or more and 1.0 mm or less and, in the present embodiment, set to 0.6 mm.

The metal layer 13 has an Al layer 13A disposed on the other surface of the ceramic substrate 11 and a Cu layer 13B laminated on a surface of the Al layer 13A opposite to the surface to which the ceramic substrate 11 is bonded as shown in Fig. 2.

The Al layer 13A is formed by bonding an aluminum plate 23A made of aluminum or an aluminum alloy to the other surface of the ceramic substrate 11 as shown in Fig. 5. In the present embodiment, the Al layer 13A is formed by bonding a rolled plate (aluminum plate 23A) of aluminum having a purity of 99 mass% or higher (2N aluminum) or aluminum having a purity of 99.99 mass% or higher (4N aluminum) to the ceramic substrate 11. The thickness of the aluminum plate 23A to be bonded is set in a range of 0.1 mm or more and 3.0 mm or less and, in the present embodiment, set to 0.6 mm.

The Cu layer 13B is formed by bonding a copper plate 23B made of copper or a copper alloy to the other surface of the Al layer 13A as shown in Fig. 5. In the present embodiment, the Cu layer 13B is formed by bonding a rolled plate (copper plate 23B) of oxygen-free copper. The thickness of the Cu layer 13B is set in a range of 0.1 mm or more and 6 mm or less and, in the present embodiment, set to 1 mm.

The heat sink 31 is a member for dissipating heat from the insulating circuit substrate 10, and, in the present embodiment, passages 32 through which a cooling medium flows are provided as shown in Fig. 2. The heat sink 31 is made of an aluminum alloy having a Si concentration set in a range of 1.5 mass% or more and 12.5 mass% or less, an Fe concentration set to 0.15 mass% or less, and a Cu concentration set to 0.05 mass% or less. In the heat sink 31 (aluminum alloy), Si precipitates are finely dispersed.

Here, the heat sink 31 and the metal layer 13 (Cu layer 13B) are bonded to each other by solid phase diffusion bonding.

In the bonding interface between the metal layer 13 (Cu layer 13B) and the heat sink 31, an intermetallic compound layer 40 is formed as shown in Fig. 3. This intermetallic compound layer 40 is formed by the mutual diffusion of Al atoms in the heat sink 31 and Cu atoms in the metal layer 13 (Cu layer 13B).

As shown in Fig. 3, the intermetallic compound layer 40 is made up of a first intermetallic compound layer 41 that is disposed on the heat sink 31 side and is made of a $\theta$ phase of an intermetallic compound of Cu and Al and a second intermetallic compound layer 42 that is disposed on the metal layer 13 side and is made of a non-$\theta$ phase other than the $\theta$ phase, such as a $\eta_2$ phase, a $\zeta_2$ phase, a $\delta$ phase, or a $\gamma_2$ phase.

Here, the thickness of the intermetallic compound layer 40 is set in a range of 10 $\mu$m or more and 80 $\mu$m or less and preferably set in a range of 20 $\mu$m or more and 50 $\mu$m or less.

In addition, the ratio t2/t1 of the thickness t2 of the second intermetallic compound layer 42 made of the non-$\theta$ phase to the thickness t1 of the first intermetallic compound layer 41 made of the $\theta$ phase is set in a range of 1.2 or more and 2.0 or less.

The lower limit of the thickness ratio t2/t1 is preferably set to 1.4 or more and more preferably set to 1.5 or more. In addition, the upper limit of the thickness ratio t2/t1 is preferably set to 1.8 or less and more preferably set to 1.6 or less.

In addition, the lower limit of the thickness t1 of the first intermetallic compound layer 41 made of the θ phase is preferably set to 5 μm or more and more preferably set to 10 μm or more. On the other hand, the upper limit of the thickness t1 of the first intermetallic compound layer 41 made of the θ phase is preferably set to 20 μm or less and more preferably set to 15 μm or less.

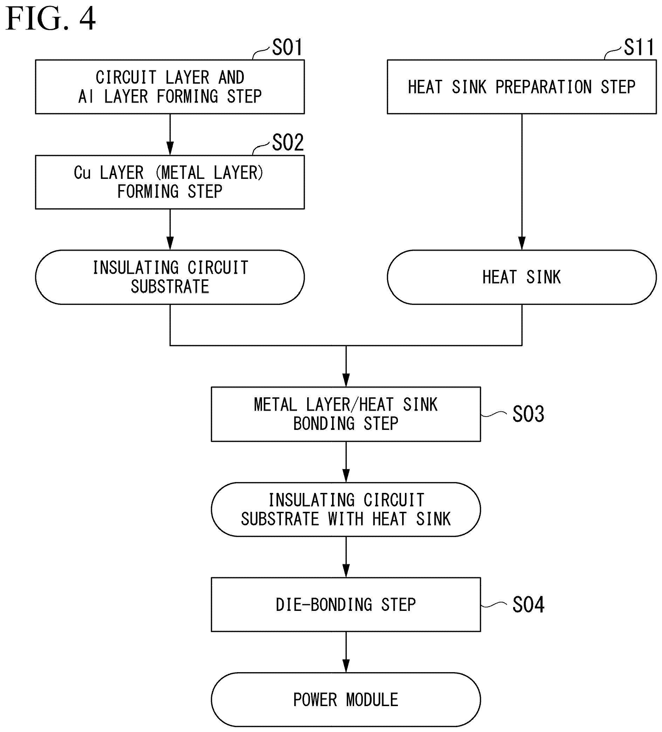

Next, a method for manufacturing the insulating circuit substrate with a heat sink 30, which is the present embodiment, will be described with reference to Fig. 4 and Fig. 5.

(Circuit layer and Al layer forming step S01)

First, as shown in Fig. 5, the aluminum plate 22 that serves as the circuit layer 12 is laminated on one surface of the ceramic substrate 11 through an Al-Si-based brazing material foil 26.

In addition, the aluminum plate 23A that serves as the Al layer 13A is laminated on the other surface of the ceramic substrate 11 through an Al-Si-based brazing material foil 26. In the present embodiment, as the Al-Si-based brazing material foil 26, a 10 μm-thick Al-8 mass% Si alloy foil was used.

In addition, the aluminum plate 22, the ceramic substrate 11 and the aluminum plate 23A are disposed and heated in a vacuum heating furnace in a state of being pressurized (at a pressure of 1 to 35 kgf/cm$^2$ (0.1 to 3.5 MPa)) in the lamination direction, thereby bonding the aluminum plate 22 and the ceramic substrate 11 to each other and forming the circuit layer 12. In addition, the ceramic substrate 11 and the aluminum plate 23A are bonded to each other, thereby forming the Al layer 13A.

Here, it is preferable that the pressure in the vacuum heating furnace is set in a range of 10$^{-6}$ Pa or more and 10$^{-3}$ Pa or less, the heating temperature is set to 600°C or higher and 650°C or lower, and the holding time at the heating temperature is set in a range of 15 minutes or longer and 180 minutes or shorter.

(Cu layer (metal layer) forming step S02)

Next, the copper plate 23B that serves as the Cu layer 13B is laminated on the other surface of the Al layer 13A.

In addition, the Al layer 13A and the copper plate 23B are disposed and heated in the vacuum heating furnace in a state of being pressurized (at a pressure of 3 to 35 kgf/cm$^2$ (0.3 to 3.5 MPa)) in the lamination direction, thereby solid-phase diffusion bonding the Al layer 13A and the copper plate 23B and forming the metal layer 13.

Here, it is preferable that the pressure in the vacuum heating furnace is set in a range of 10$^{-6}$ Pa or more and 10$^{-3}$ Pa or less, the heating temperature is set to 400°C or higher and 548°C or lower, and the holding time at the heating temperature is set in a range of 5 minutes or longer and 240 minutes or shorter.

The bonding surfaces of the Al layer 13A and the copper plate 23B, which are to be bonded to each other by solid phase diffusion bonding, are each flattened by removing damage on the surfaces in advance.

As described above, the insulating circuit substrate 10 is manufactured.

(Heat sink preparation step S11)

Meanwhile, the heat sink 31 is prepared. First, an aluminum alloy plate that serves as a material for the heat sink 31 is manufactured. Specifically, a molten aluminum alloy having components adjusted such that the Si concentration falls in a range of 1.5 mass% or more and 12.5 mass% or less, the Fe concentration reaches 0.15 mass% or less, and the Cu concentration reaches 0.05 mass% or less is produced. In addition, an aluminum alloy plate is manufactured using this molten aluminum alloy by a twin-roll method. In the twin-roll method, Si precipitates are finely dispersed since the cooling rate becomes fast.

In addition, the aluminum alloy plate is processed to form the heat sink 31.

(Metal layer/heat sink bonding step S03)

Next, the metal layer 13 (Cu layer 13B) of the insulating circuit substrate 10 and the heat sink 31 are laminated together and disposed and heated in the vacuum heating furnace in a state of being pressurized (at a pressure of 5 to 35 kgf/cm$^2$ (0.5 to 3.5 MPa)) in the lamination direction, thereby solid-phase diffusion bonding the metal layer 13 (Cu layer 13B) and the heat sink 31. The bonding surfaces of the metal layer 13 (Cu layer 13B) and the heat sink 31, which are to be bonded to each other by solid phase diffusion bonding, are each flattened by removing damage on the surfaces in advance.

Here, it is preferable that the pressure in the vacuum heating furnace is set in a range of 10$^{-6}$ Pa or more and

10^{-3} Pa or less, the heating temperature is set to 400°C or higher and 520°C or lower, and the holding time at the heating temperature is set in a range of 15 minutes or longer and 300 minutes or shorter.

In this metal layer/heat sink bonding step S03, Cu atoms in the Cu layer 13B and Al atoms in the heat sink 31 mutually diffuse, thereby forming the intermetallic compound layer 40 in which the first intermetallic compound layer 41 made of the θ phase and the second intermetallic compound layer 42 made of the non-θ phase are laminated as shown in Fig. 3.

The insulating circuit substrate with a heat sink 30, which is the present embodiment, is manufactured as described above.

Here, in the present embodiment, since the heat sink 31 is formed using the aluminum alloy plate manufactured by the twin-roll method as described above, Si precipitates are finely dispersed in the heat sink 31. Since Si has a faster Cu diffusion rate than Al, the dispersed Si precipitates accelerate the diffusion of Cu and cause the θ phase to significantly grow. Therefore, the ratio t2/t1 of the thickness t2 of the second intermetallic compound layer 42 made of the non-θ phase to the thickness t1 of the first intermetallic compound layer 41 made of the θ phase falls in a range of 1.2 or more and 2.0 or less. In addition, since coarse Si precipitates are not present in the heat sink 31, it is possible to suppress the excessive formation of Kirkendall voids.

(Die-bonding step S04)

Next, the semiconductor element 3 is laminated on one surface (front surface) of the circuit layer 12 through a solder material and bonded in a reducing furnace with solder.

The power module 1, which is the present embodiment, is manufactured as described above.

According to the insulating circuit substrate with a heat sink 30 according to the present embodiment configured as described above, since the heat sink 31 is made of the aluminum alloy having a Si concentration set in a range of 1.5 mass% or more and 12.5 mass% or less, an Fe concentration set to 0.15 mass% or less, and a Cu concentration set to 0.05 mass% or less, the strength of the heat sink 31 is high, and it is possible to fasten the heat sink with a screw and to suppress the warpage of the heat sink. In addition, since the thermal conductivity of the heat sink 31 becomes relatively high, the heat radiation characteristic is excellent.

In addition, in the present embodiment, in the intermetallic compound layer 40 formed in the bonding interface between the heat sink 31 and the metal layer 13, the ratio t2/t1 of the thickness t2 of the second intermetallic compound layer 42 that is positioned on the metal layer 13 side and is made of the non-θ phase other than the θ phase to the thickness t1 of the first intermetallic compound layer 41 that is positioned on the heat sink 31 side and is made of the θ phase is set to 1.2 or more. Therefore, the thickness of the first intermetallic compound layer 41 made of the θ phase is not thicker than necessary, and the generation of a breaking attributed to the first intermetallic compound layer 41 can be suppressed. In addition, the thickness of the second intermetallic compound layer 42 that is positioned on the metal layer 13 side and is made of the non-θ phase is secured, whereby the deformation resistance of the metal layer 13 becomes high, even in a case where an external force is applied, the metal layer 13 does not easily deform, and the generation of a breaking in the intermetallic compound layer 40 can be suppressed.

Furthermore, since the ratio t2/t1 of the thickness t2 of the second intermetallic compound layer 42 to the thickness t1 of the first intermetallic compound layer 41 is set to 2.0 or less, the thickness of the first intermetallic compound layer 41 that is positioned on the heat sink 31 side and is made of the θ phase is secured. Therefore, the deformation resistance of the heat sink 31 becomes high, even in a case where an external force is applied, the heat sink 31 does not easily deform, and the generation of a breaking in the intermetallic compound layer 40 can be suppressed.

(Second embodiment)

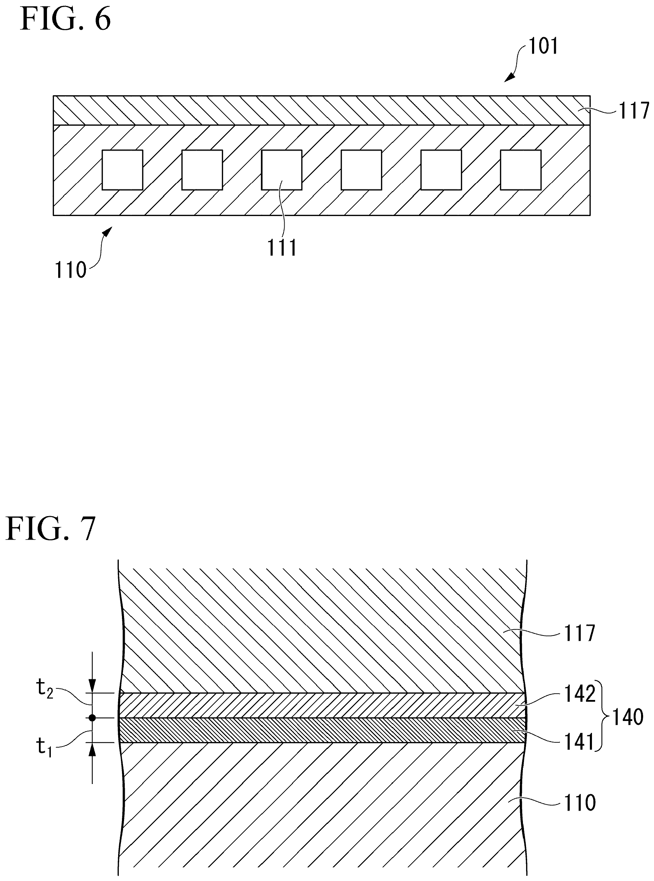

Next, a heat sink, which is a second embodiment of the present invention, will be described. Fig. 6 shows a heat sink 101 according to the second embodiment of the present invention.

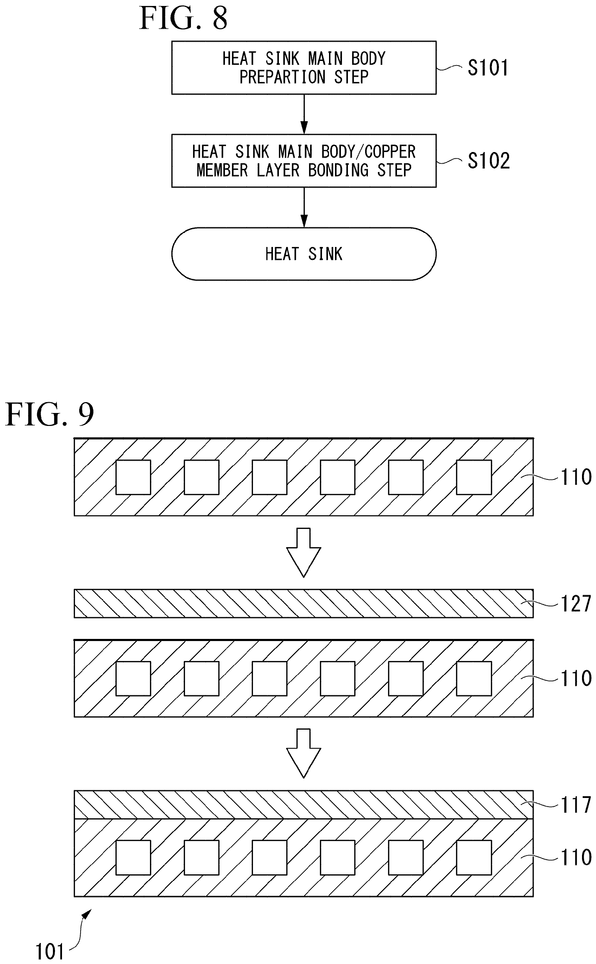

This heat sink 101 includes a heat sink main body 110 and a copper member layer 117 that is laminated on one surface (upper side in Fig. 6) of the heat sink main body 110 and is made of copper or a copper alloy. In the present embodiment, the copper member layer 117 is configured by bonding a copper plate 127 made of a rolled plate of oxygen-free copper as shown in Fig. 9.

The heat sink main body 110 is provided with passages 111 through which a cooling medium flows. The heat sink main body 110 is made of an aluminum alloy having a Si concentration set in a range of 1.5 mass% or more and 12.5 mass% or less, an Fe concentration set to 0.15 mass% or less, and a Cu concentration set to 0.05 mass% or less. In the heat sink main body 110 (aluminum alloy), Si precipitates are finely dispersed.

Here, the heat sink main body 110 and the copper member layer 117 are bonded to each other by solid phase diffusion bonding.

In the bonding interface between the heat sink main body 110 and the copper member layer 117, an intermetallic compound layer 140 containing Al and Cu is formed as shown in Fig. 7. This intermetallic compound layer 140 is formed by the mutual diffusion of Al atoms in the heat sink main body 110 and Cu atoms in the copper member layer 117.

As shown in Fig. 7, the intermetallic compound layer 140 is made up of a first intermetallic compound layer 141 made of a $\theta$ phase of an intermetallic compound of Cu and Al disposed on the heat sink main body 110 side and a second intermetallic compound layer 142 that is disposed on the copper member layer 117 side and is made of a non-$\theta$ phase other than the $\theta$ phase, such as a $\eta_2$ phase, a $\zeta_2$ phase, a $\delta$ phase, or a $\gamma_2$ phase.

Here, the thickness of the intermetallic compound layer 140 is set in a range of 10 $\mu$m or more and 80 $\mu$m or less and preferably set in a range of 20 $\mu$m or more and 50 $\mu$m or less.

In addition, the ratio t2/t1 of the thickness t2 of the second intermetallic compound layer 142 made of the non-$\theta$ phase to the thickness t1 of the first intermetallic compound layer 141 made of the $\theta$ phase is set in a range of 1.2 or more and 2.0 or less.

The lower limit of the thickness ratio t2/t1 is preferably set to 1.4 or more and more preferably set to 1.5 or more. In addition, the upper limit of the thickness ratio t2/t1 is preferably set to 1.8 or less and more preferably set to 1.6 or less.

In addition, the lower limit of the thickness t1 of the first intermetallic compound layer 141 made of the $\theta$ phase is preferably set to 5 $\mu$m or more and more preferably set to 10 $\mu$m or more. On the other hand, the upper limit of the thickness t1 of the first intermetallic compound layer 141 made of the $\theta$ phase is preferably set to 20 $\mu$m or less and more preferably set to 15 $\mu$m or less.

Next, a method for manufacturing the heat sink 101, which is the present embodiment, will be described with reference to Fig. 8 and Fig. 9.

(Heat sink main body preparation step S101)

The heat sink main body 110 to be bonded is prepared. First, an aluminum alloy plate that serves as a material for the heat sink main body 110 is manufactured. Specifically, a molten aluminum alloy having components adjusted such that the Si concentration falls in a range of 1.5 mass% or more and 12.5 mass% or less, the Fe concentration reaches 0.15 mass% or less, and the Cu concentration reaches 0.05 mass% or less is produced. In addition, an aluminum alloy plate is manufactured using this molten aluminum alloy by a twin-roll method.

In the twin-roll method, Si precipitates are finely dispersed since the cooling rate becomes fast.

In addition, the aluminum alloy plate is processed to form the heat sink main body 110.

(Heat sink main body/copper member layer bonding step S102)

Next, as shown in Fig. 9, the heat sink main body 110 and the copper plate 127 that serves as the copper member layer 117 are laminated together and disposed and heated in a vacuum heating furnace in a state of being pressurized (at a pressure of 5 to 35 kgf/cm$^2$ (0.5 to 3.5 MPa)) in the lamination direction, thereby solid-phase diffusion bonding the copper plate 127 and the heat sink main body 110. The bonding surfaces of the copper plate 127 and the heat sink main body 110, which are to be bonded to each other by solid phase diffusion bonding, are each flattened by removing damage on the surfaces in advance.

Here, it is preferable that the pressure in the vacuum heating furnace is set in a range of 10$^{-6}$ Pa or more and 10$^{-3}$ Pa or less, the heating temperature is set to 450°C or higher and 520°C or lower, and the holding time at the heating temperature is set in a range of 15 minutes or longer and 300 minutes or shorter.

In this heat sink main body/copper member layer bonding step S102, Cu atoms in the copper member layer 117 (copper plate 127) and Al atoms in the heat sink main body 110 mutually diffuse, thereby forming the intermetallic compound layer 140 in which the first intermetallic compound layer 141 made of the $\theta$ phase and the second intermetallic compound layer 142 made of the non-$\theta$ phase are laminated as shown in Fig. 7.

The heat sink 101, which is the present embodiment, is manufactured as described above.

Here, in the present embodiment, since the heat sink main body 110 is formed using the aluminum alloy plate manufactured by the twin-roll method as described above, Si precipitates are finely dispersed in the heat sink main body 110. Since Si has a faster Cu diffusion rate than Al, the dispersed Si precipitates accelerate the diffusion of Cu and cause the $\theta$ phase to significantly grow. Therefore, the ratio t2/t1 of the thickness t2 of the second intermetallic compound layer 142 made of the non-$\theta$ phase to the thickness t1 of the first intermetallic compound layer 141 made of the $\theta$ phase falls in a range of 1.2 or more and 2.0 or less. In addition, since coarse Si precipitates are not present in the heat sink main body 110, it is possible to suppress the excessive formation of Kirkendall voids.

According to the heat sink 101 according to the present embodiment configured as described above, since the copper member layer 117 is formed by bonding the copper plate 127 made of a rolled plate of oxygen-free copper to one surface side of the heat sink main body 110, it is possible to spread heat in the surface direction through the copper member layer 117 and to significantly improve the heat radiation characteristic. In addition, it is possible to favorably bond other members and the heat sink 101 using solder or the like.

In addition, in the present embodiment, since the heat sink main body 110 is made of the aluminum alloy having a Si concentration set in a range of 1.5 mass% or more and 12.5 mass% or less, an Fe concentration set to 0.15 mass% or less, and a Cu concentration set to 0.05 mass% or less, the strength of the heat sink main body 110 is high, and it is possible to fasten the heat sink with a screw, to suppress the warpage of the heat sink, and to attach the heat sink to a cooler or the like. In addition, since the thermal conductivity of the heat sink main body 110 becomes relatively high, the heat radiation characteristic is excellent.

In addition, in the intermetallic compound layer 140 formed in the bonding interface between the heat sink main body 110 and the copper member layer 117, since the ratio t2/t1 of the thickness t2 of the second intermetallic compound layer 142 that is positioned on the copper member layer 117 side and is made of the non-θ phase other than the θ phase to the thickness t1 of the first intermetallic compound layer 141 that is positioned on the heat sink main body 110 side and is made of the θ phase is set to 1.2 or more, the thickness of the first intermetallic compound layer 141 made of the θ phase is not thicker than necessary, and the generation of a breaking attributed to the first intermetallic compound layer 141 can be suppressed. In addition, since the thickness of the second intermetallic compound layer 142 that is positioned on the copper member layer 117 side and is made of the non-θ phase is secured, the deformation resistance of the copper member layer 117 becomes high, even in a case where an external force is applied due to fastening or the like, the copper member layer 117 does not easily deform, and the generation of a breaking in the intermetallic compound layer 140 can be suppressed.

Furthermore, since the ratio t2/t1 of the thickness t2 of the second intermetallic compound layer 142 to the thickness t1 of the first intermetallic compound layer 141 is set to 2.0 or less, the thickness of the first intermetallic compound layer 141 that is positioned on the heat sink main body 110 side and is made of the θ phase is secured. Therefore, the deformation resistance of the heat sink main body 110 becomes high, even in a case where an external force is applied due to fastening or the like, the heat sink main body 110 does not easily deform, and the generation of a breaking in the intermetallic compound layer 140 can be suppressed.

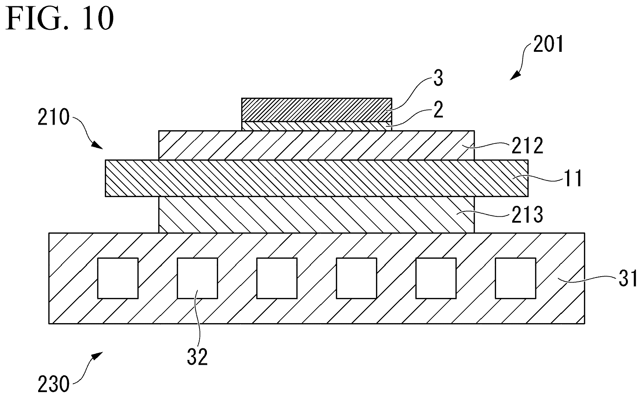

Hitherto, the embodiments of the present invention have been described, but the present invention is not limited thereto and can be appropriately modified within the scope of the technical concept of the invention. For example, in the first embodiment, the metal layer 13 has been described as having the Al layer 13A and the Cu layer 13B, but the configuration is not limited thereto, and the entire metal layer may be made of copper or a copper alloy as shown in Fig. 10. In an insulating circuit substrate with a heat sink 230 shown in Fig. 10, a copper plate is bonded to the other surface (lower side in Fig. 10) of the ceramic substrate 11 by a DBC method, an active metal brazing method, or the like to form a metal layer 213 made of copper or a copper alloy. In addition, the metal layer 213 and the heat sink 31 are bonded to each other by solid phase diffusion bonding. In an insulating circuit substrate 210 shown in Fig. 10, a circuit layer 212 is also made of copper or a copper alloy.

In addition, in the first embodiment, the circuit layer has been described as being formed by bonding the aluminum plate having a purity of 99 mass%, but the configuration is not limited thereto. The circuit layer may be made of different metal such as pure aluminum having a purity of 99.99 mass% or higher, different aluminum or a different aluminum alloy, or copper or a copper alloy. In addition, the circuit layer may be provided with a bilayer structure of an Al layer and a Cu layer. This is also true for the insulating circuit substrate 210 shown in Fig. 10.

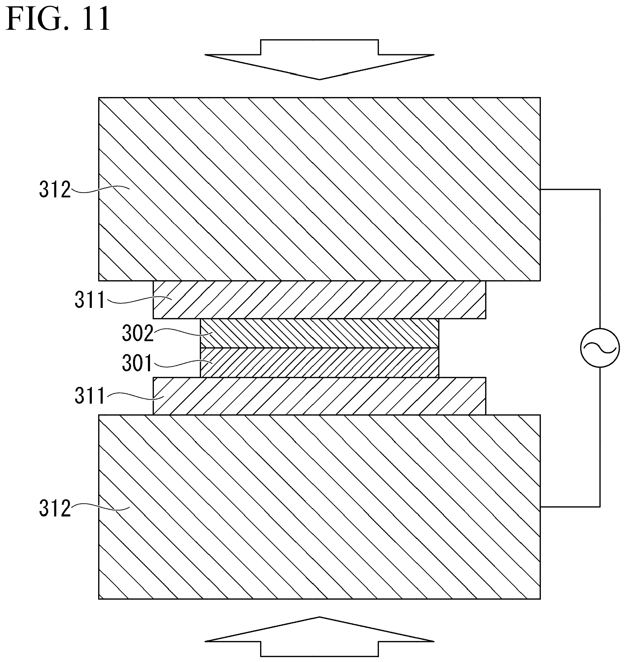

In addition, in the metal layer/heat sink bonding step S03 of the first embodiment, the metal layer 13 (Cu layer 13B) and the heat sink 31 are laminated and disposed and heated in the vacuum heating furnace in a state of being pressurized in the lamination direction. Furthermore, in the heat sink main body/copper member layer bonding step S102 of the second embodiment, the heat sink main body 110 and the copper plate 127 that serves as the copper member layer 117 have been described as being laminated together and disposed and heated in the vacuum heating furnace in a state of being pressurized (at a pressure of 5 to 35 kgf/cm$^2$ (0.5 to 3.5 MPa)) in the lamination direction. However, the present invention is not limited to the first embodiment or the second embodiment, and an electric heating method may be applied at the time of bonding an aluminum alloy member 301 (heat sink 31 or heat sink main body 110) and a copper member 302 (metal layer 13 or copper member layer 117) to each other by solid phase diffusion bonding as shown in Fig. 11.

In the case of performing electric heating, as shown in Fig. 11, the aluminum alloy member 301 and the copper member 302 are laminated, the laminate of the aluminum alloy member 301 and the copper member 302 is pressured in the lamination direction with a pair of electrodes 312 and 312 through carbon plates 311 and 311, and energization is performed on the aluminum alloy member 301 and the copper member 302. Then, the carbon plates 311 and 311, the aluminum alloy member 301, and the copper member 302 are heated by Joule heat, whereby the aluminum alloy member 301 and the copper member 302 are bonded to each other by solid phase diffusion bonding.

In the electric heating method, since the aluminum alloy member 301 and the copper member 302 are directly ohmic-heated, it is possible to make the temperature increase rate as relatively fast as, for example, 30 to 100 °C/min and to perform solid-phase diffusion bonding within a short period of time. Therefore, the influence of the oxidation of the bonding surface is small, and it becomes possible to bond the aluminum alloy member 301 and the copper member 302 even in, for example, the ambient atmosphere. In addition, depending on the resistance values or specific heats of the aluminum alloy member 301 and the copper member 302, it also becomes possible to bond the aluminum alloy member 301 and the copper member 302 even in a state where there is a temperature difference between the aluminum alloy member 301 and the copper member 302, and it is also possible to decrease the difference in thermal expansion and also to reduce thermal stress.

Here, in the electric heating method, the pressurization load with the pair of electrodes 312 and 312 is preferably set in a range of 30 kgf/cm$^2$ or more and 100 kgf/cm$^2$ or less (3 MPa or more and 10 MPa or less).

In addition, in the case of applying the electric heating method, the surface roughness of the aluminum alloy member 301 and the copper member 302 is preferably set in a range of 0.3 μm or more and 0.6 μm or less in terms of the arithmetic average roughness Ra (JIS B 0601:2001) or set in a range of 1.3 μm or more and 2.3 μm or less in terms of the maximum height Rz (JIS B 0601:2001). In ordinary solid-phase diffusion bonding, the surface roughness of a bonding surface is preferably small. However, in the case of the electric heating method, an excessively small surface roughness of a bonding surface decreases the interface contact resistance and makes it difficult to locally heat the bonding interface. Therefore, the surface roughness is preferably set in the above-described ranges.

It is also possible to use the above-described electric heating method in the metal layer/heat sink bonding step S03 of the first embodiment. However, in this case, since the ceramic substrate 11 is an insulator, it is necessary to short-circuit the carbon plates 311 and 311 with, for example, a carbon jig or the like. The bonding conditions are the same as those for the bonding of the aluminum alloy member 301 and the copper member 302.

In addition, for the surface roughness of the metal layer 13 (Cu layer 13B) and the heat sink 31, the above description of the surface roughness of the aluminum alloy member 301 and the copper member 302 is also true.

EXAMPLES

Hereinafter, the results of confirmatory experiments performed to confirm the effect of the present invention will be described.

(Production of test pieces)

A copper plate made of oxygen-free copper (40 mm x 40 mm, 5 mm in thickness) was bonded to one surface of an aluminum alloy plate (50 mm x 50 mm, 5 mm in thickness) shown in Table 1 by solid phase diffusion bonding by the method described in the embodiments. In present invention examples, the aluminum alloy plates were manufactured by the twin-roll method. In comparative examples, aluminum alloy plates were manufactured by manufacturing a block-shaped ingot and performing hot rolling and cold rolling on the block-shaped ingot.

In addition, in the present invention examples and the comparative examples, the aluminum alloy plate and the copper plate were pressurized with a load of 15 kgf/cm$^2$ (1.5 MPa) in the lamination direction and bonded to each other by solid phase diffusion bonding in a vacuum heating furnace at 500°C for a holding time shown in Table 1.

(Hardness of aluminum alloy plates)

The indentation hardness of each of the aluminum alloy plates in bonded bodies was measured by the nanoindentation method (measuring instrument: ENT-1100a (ELIONIX INC.)). The indentation hardness was measured at 10 places in the central portion of the aluminum alloy plate in the thickness direction, and the average value was obtained. The indentation hardness was obtained from the formula: indentation hardness = $37.926 \times 10^{-3} \times$ (load [mgf] ÷ displacement [μm]$^2$) after measuring the correlation between the load and the displacement at the time of applying a test load set to 5000 mgf using a triangular pyramid diamond indenter having an angle of ridge-to-ridge of 114.8° or more and 115.1° or less, which is referred to as the Berkovich indenter.

(Evaluation of intermetallic compound layers)

A cross section of each of the bonded bodies of the aluminum alloy plate and the copper plate that were bonded to each other by solid phase diffusion bonding was observed, and, in an intermetallic compound layer formed in the bonding interface, the thicknesses t1 of a θ phase and the thicknesses t2 of a non-θ phase were measured.

Using EPMA (JXA-8530F: JEOL Ltd.), a line analysis was performed in the thickness direction at the position where the intermetallic compound layer was included. With respect to the total amount of Cu and Al considered as 100 atom%, a region where the Cu concentration was 30 to 35 atom% was regarded as the θ phase, and a region where the Cu concentration was 46 to 72 atom% was regarded as the non-θ phase. A place where a local peak was present due to Si precipitates was excluded.

The cross section was observed at 5 visual fields, and the average value of the thicknesses t1 of the θ phase and the average value of the thicknesses t2 of the non-θ phase were calculated. The measurement results are shown in Table 1.

(Thermal cycle test)

Next, on each of the bonded bodies manufactured as described above, a thermal cycle test was performed. A thermal cycle of -50°C for 45 minutes and 175°C for 45 minutes was performed 2,500 times in an air chamber on each of the test pieces (power modules with a heat sink) using a thermal shock tester TSA-72ES manufactured by ESPEC Corp.
In addition, the heat resistances and bonding rates in the lamination direction of the bonded bodies before the thermal cycle test and the heat resistances and bonding rates in the lamination direction of the bonded bodies after the thermal cycle test were evaluated as described below.

(Evaluation of bonding rates)

The bonding rates of the bonding parts between the aluminum alloy plate and the metal plate in the bonded bodies were evaluated using an ultrasonic flaw detector (FineSAT200: Hitachi Solutions, Ltd.) and calculated from the following formula. Here, the initial bonding area was defined as the area to be bonded before bonding, that is, the area of the aluminum alloy plate. In an ultrasonic-detected image, peeling appeared as a white portion, and thus the area of the white portion was regarded as the exfoliation area. The evaluation results are shown in Table 1.

$$\text{Bonding rate } (\%) = \{(\text{initial bonding area}) - (\text{exfoliation area})\}/(\text{initial bonding area}) \times 100$$

(Measurement of heat resistances)

A heater chip (13 mm x 10 mm x 0.25 mm) was soldered to the surface of the metal plate, and the aluminum alloy plate was bonded to a cooler by brazing. Next, the heater chip was heated with a power of 100 W, and the temperature of the heater chip was measured using a thermocouple (K thermocouple, class 1). In addition, the temperature of a cooling medium (ethylene glycol:water = 9:1) flowing in the cooler was measured. In addition, a value obtained by dividing the difference between the temperature of the heater chip and the temperature of the cooling medium by the power was regarded as the heat resistance.
The heat resistance before the thermal cycle test in Comparative Example 1 was regarded as 1 as a reference, and the heat resistances in other examples were evaluated using the ratios of those to the heat resistance in Comparative Example 1. The evaluation results are shown in Table 1.

[Table 1]

| | Aluminium alloy plate | | | | Bonding condition | Intermetallic compound layer | | | Bonded body | | | |
|---|---|---|---|---|---|---|---|---|---|---|---|---|
| | Composition (mass%) | | | Hardness (Hv) | Holding time (min) | θ phase thickness t1 (μm) | Non-θ phase thickness t2 (μm) | Thickness ratio t2/t1 | Before application of thermal cycle | | After application of thermal cycle | |
| | Si | Fe | Cu | | | | | | Bonding rate (%) | Heat resistance | Bonding rate (%) | Heat resistance |
| Present Invention Example 1 | 1.5 | 0.05 | 0.03 | 96 | 120 | 8.9 | 18.0 | 2.0 | 98.4 | 0.996 | 91.7 | 1.069 |
| Present Invention Example 2 | 12.5 | 0.05 | 0.01 | 164 | 15 | 5.9 | 7.0 | 1.2 | 97.0 | 0.963 | 90.2 | 1.036 |
| Present Invention Example 3 | 3.5 | 0.15 | 0.01 | 113 | 90 | 9.7 | 15.3 | 1.6 | 99.1 | 0.990 | 91.6 | 1.071 |
| Present Invention Example 4 | 10.5 | 0.08 | 0.05 | 150 | 90 | 9.9 | 16.4 | 1.6 | 98.3 | 0.969 | 92.0 | 1.035 |
| Present Invention Example 5 | 5.5 | 0.05 | 0.01 | 122 | 300 | 15.5 | 27.9 | 1.8 | 99.5 | 0.984 | 93.5 | 1.047 |
| Present Invention Example 6 | 10.5 | 0.02 | 0.00 | 142 | 240 | 16.4 | 25.6 | 1.6 | 99.2 | 0.969 | 96.0 | 1.001 |
| Present Invention Example 7 | 7.5 | 0.01 | 0.03 | 126 | 90 | 10.4 | 15.1 | 1.5 | 98.8 | 0.978 | 96.8 | 0.998 |
| Present Invention Example 8 | 7.5 | 0.05 | 0.03 | 123 | 90 | 10.6 | 14.7 | 1.4 | 97.5 | 0.978 | 94.5 | 1.009 |
| Comparative Example 1 | 0.2 | 0.02 | 0.03 | 43 | 120 | 6.2 | 17.1 | 2.8 | 97.5 | 1.000 | 87.2 | 1.118 |

|  | Aluminium alloy plate | | | | Bonding condition | Bonded body | | | | | | | |
|  | Composition (mass%) | | | Hardness (Hv) | Holding time (min) | Intermetallic compound layer | | | Before application of thermal cycle | | After application of thermal cycle | |
|  | Si | Fe | Cu | | | $\theta$ phase thickness t1 ($\mu$m) | Non-$\theta$ phase thickness t2 ($\mu$m) | Thickness ratio t2/t1 | Bonding rate (%) | Heat resistance | Bonding rate (%) | Heat resistance |
| Comparative Example 2 | 18.5 | 0.05 | 0.00 | 183 | 15 | 6.8 | 7.1 | 1.0 | 99.1 | 0.945 | 83.9 | 1.116 |
| Comparative Example 3 | 7.5 | 0.42 | 0.03 | 122 | 90 | 9.8 | 16.7 | 1.7 | 99.1 | 0.978 | 86.8 | 1.117 |
| Comparative Example 4 | 7.5 | 0.05 | 0.26 | 139 | 90 | 9.7 | 15.9 | 1.6 | 99.5 | 0.978 | 86.6 | 1.124 |

EP 3 888 836 A1

In Comparative Example 1, the Si concentration of the aluminum alloy plate was 0.2 mass%, which was below the range of the present invention, the ratio t2/t1 of the non-θ phase thickness t2 to the θ phase thickness t1 was 2.8, which was above the range of the present invention, and, after the application of the thermal cycle, the bonding rate decreased, and the heat resistance significantly increased.

In Comparative Example 2, the Si concentration of the aluminum alloy plate was 18.5 mass%, which was above the range of the present invention, the ratio t2/t1 of the non-θ phase thickness t2 to the θ phase thickness t1 was 1.0, which was below the range of the present invention, and, after the application of the thermal cycle, the bonding rate decreased, and the heat resistance significantly increased.

In Comparative Example 3, the Fe concentration of the aluminum alloy plate was 0.42 mass%, which was above the range of the present invention, and, after the application of the thermal cycle, the bonding rate decreased, and the heat resistance significantly increased.

In Comparative Example 4, the Cu concentration of the aluminum alloy plate was 0.26 mass%, which was above the range of the present invention, and, after the application of the thermal cycle, the bonding rate significantly decreased, and the heat resistance significantly increased.

In contrast, in Present Invention Examples 1 to 8 where the Si concentrations, the Fe concentrations, and the Cu concentrations of the aluminum alloy plates, and the ratios t2/t1 of the non-θ phase thickness t2 to the θ phase thickness t1 were within the ranges of the present invention, respectively, the heat resistances became low compared with those in Comparative Example 1. In addition, even after the application of the thermal cycle, the bonding rates did not significantly decrease, and the heat resistances also did not significantly increase.

From the above-described results, it was confirmed that, according to Present Invention Examples 1 to 8, it is possible to provide a bonded body that includes an aluminum alloy member made of an aluminum alloy and a copper member made of copper or a copper alloy, the aluminum alloy member and the copper member being bonded to each other by solid phase diffusion bonding, has excellent thermal cycle reliability, and is excellent in terms of the heat radiation characteristic and the strength.

INDUSTRIAL APPLICABILITY

The bonded body of the present invention, an insulating circuit substrate with a heat sink and a heat sink both including the bonded body can be preferably used in devices having a control circuit provided with a power semiconductor element for high-power control from which a large amount of heat is generated, for example, wind-power generators, electric vehicles, hybrid vehicles, and the like.

REFERENCE SIGNS LIST

| | |
|---|---|
| 10, 210 | Insulating circuit substrate |
| 11 | Ceramic substrate |
| 13, 213 | Metal layer |
| 13B | Cu layer (copper member) |
| 31 | Heat sink (aluminum alloy member) |
| 40 | Intermetallic compound layer |
| 41 | First intermetallic compound layer |
| 42 | Second intermetallic compound layer |
| 101 | Heat sink |
| 110 | Heat sink main body (aluminum alloy member) |
| 117 | Copper member layer |
| 140 | Intermetallic compound layer |
| 141 | First intermetallic compound layer |
| 142 | Second intermetallic compound layer |

**Claims**

1. A bonded body comprising:

   a copper member made of copper or a copper alloy; and
   an aluminum alloy member made of an aluminum alloy containing Si, the copper member and the aluminum

15

alloy member being bonded to each other,
wherein the aluminum alloy has a Si concentration being in a range of 1.5 mass% or more and 12.5 mass% or less, an Fe concentration being 0.15 mass% or less, and a Cu concentration being 0.05 mass% or less,
the aluminum alloy member and the copper member are bonded to each other by solid phase diffusion bonding,
in a bonding interface between the aluminum alloy member and the copper member, an intermetallic compound layer made of an intermetallic compound containing Cu and Al is provided,
in the intermetallic compound layer, a first intermetallic compound layer that is positioned on the aluminum alloy member side and is made of a $\theta$ phase and a second intermetallic compound layer that is positioned on the copper member side and is made of a non-$\theta$ phase other than the $\theta$ phase are laminated, and
a ratio t2/t1 of a thickness t2 of the second intermetallic compound layer made of the non-$\theta$ phase to a thickness t1 of the first intermetallic compound layer made of the $\theta$ phase is in a range of 1.2 or more and 2.0 or less.

2. An insulating circuit substrate with a heat sink comprising:

an insulating layer;
a circuit layer formed on one surface of the insulating layer;
a metal layer formed on the other surface of the insulating layer; and
a heat sink disposed on a surface of the metal layer opposite to the insulating layer,
wherein a bonding surface of the metal layer with the heat sink is made of copper or a copper alloy,
a bonding surface of the heat sink with the metal layer is made of an aluminum alloy having a Si concentration being in a range of 1.5 mass% or more and 12.5 mass% or less, an Fe concentration being 0.15 mass% or less, and a Cu concentration being 0.05 mass% or less,
the heat sink and the metal layer are bonded to each other by solid phase diffusion bonding,
in a bonding interface between the heat sink and the metal layer, an intermetallic compound layer made of an intermetallic compound containing Cu and Al is provided,
in the intermetallic compound layer, a first intermetallic compound layer that is positioned on the heat sink side and is made of a $\theta$ phase and a second intermetallic compound layer that is positioned on the metal layer side and is made of a non-$\theta$ phase other than the $\theta$ phase are laminated, and
a ratio t2/t1 of a thickness t2 of the second intermetallic compound layer made of the non-$\theta$ phase to a thickness t1 of the first intermetallic compound layer made of the $\theta$ phase is in a range of 1.2 or more and 2.0 or less.

3. A heat sink comprising:

a heat sink main body; and
a copper member layer that is bonded to the heat sink main body and is made of copper or a copper alloy,
wherein the heat sink main body is made of an aluminum alloy having a Si concentration being in a range of 1.5 mass% or more and 12.5 mass% or less, an Fe concentration being 0.15 mass% or less, and a Cu concentration being 0.05 mass% or less,
the heat sink main body and the copper member layer are bonded to each other by solid phase diffusion bonding,
in a bonding interface between the heat sink main body and the copper member layer, an intermetallic compound layer made of an intermetallic compound containing Cu and Al is provided,
in the intermetallic compound layer, a first intermetallic compound layer that is positioned on the heat sink main body side and is made of a $\theta$ phase and a second intermetallic compound layer that is positioned on the copper member layer side and is made of a non-$\theta$ phase other than the $\theta$ phase are laminated, and
a ratio t2/t1 of a thickness t2 of the second intermetallic compound layer made of the non-$\theta$ phase to a thickness t1 of the first intermetallic compound layer made of the $\theta$ phase is in a range of 1.2 or more and 2.0 or less.

# FIG. 1

EP 3 888 836 A1

FIG. 2

FIG. 3

# FIG. 4

```
┌─────────────────────────┐ ⌐S01          ┌─────────────────────────────┐ ⌐S11
│   CIRCUIT LAYER AND     │               │  HEAT SINK PREPARATION STEP │
│  Al LAYER FORMING STEP  │               │                             │
└─────────────────────────┘               └─────────────────────────────┘
            │                                            │
            ▼          ⌐S02                              │
┌─────────────────────────┐                              │
│  Cu LAYER (METAL LAYER) │                              │
│      FORMING STEP       │                              │
└─────────────────────────┘                              │
            │                                            │
            ▼                                            ▼
   ╭─────────────────────╮                     ╭──────────────────────╮
   │ INSULATING CIRCUIT  │                     │      HEAT SINK       │
   │     SUBSTRATE       │                     │                      │
   ╰─────────────────────╯                     ╰──────────────────────╯
            │                                            │
            └──────────────────┬─────────────────────────┘
                               ▼
              ┌─────────────────────────────┐
              │  METAL LAYER/HEAT SINK      │ ⌐S03
              │       BONDING STEP          │
              └─────────────────────────────┘
                               │
                               ▼
              ╭─────────────────────────────╮
              │    INSULATING CIRCUIT       │
              │  SUBSTRATE WITH HEAT SINK   │
              ╰─────────────────────────────╯
                               │
                               ▼
              ┌─────────────────────────────┐
              │      DIE-BONDING STEP       │ ⌐S04
              └─────────────────────────────┘
                               │
                               ▼
              ╭─────────────────────────────╮
              │        POWER MODULE         │
              ╰─────────────────────────────╯
```

## FIG. 5

FIG. 6

FIG. 7

## FIG. 8

```
┌─────────────────────────────┐
│   HEAT SINK MAIN BODY        │──── S101
│   PREPARTION STEP            │
└─────────────────────────────┘
              │
              ▼
┌─────────────────────────────┐
│ HEAT SINK MAIN BODY/COPPER   │──── S102
│ MEMBER LAYER BONDING STEP    │
└─────────────────────────────┘
              │
              ▼
     ╭─────────────────────╮
     │      HEAT SINK       │
     ╰─────────────────────╯
```

## FIG. 9

FIG. 10

FIG. 11

312

311

302

301

311

312

## INTERNATIONAL SEARCH REPORT

International application No.

PCT/JP2019/046332

### A. CLASSIFICATION OF SUBJECT MATTER

Int. Cl. B23K20/00(2006.01)i, C22C21/00(2006.01)i, H01L23/36(2006.01)i, H01L23/40(2006.01)i

FI: H01L23/36 C, H01L23/40 F, B23K20/00 310H, B23K20/00 310L, C22C21/00 E

According to International Patent Classification (IPC) or to both national classification and IPC

### B. FIELDS SEARCHED

Minimum documentation searched (classification system followed by classification symbols)

Int. Cl. B23K20/00, C22C21/00, H01L23/36, H01L23/40

Documentation searched other than minimum documentation to the extent that such documents are included in the fields searched

Published examined utility model applications of Japan    1922-1996
Published unexamined utility model applications of Japan    1971-2020
Registered utility model specifications of Japan    1996-2020
Published registered utility model applications of Japan    1994-2020

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2016-168625 A (MITSUBISHI MATERIALS CORP.) 23 September 2016, paragraphs [0024]-[0030], [0044]-[0047], fig. 1, 5 | 1-3 |

☐ Further documents are listed in the continuation of Box C.      ☒ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 31.01.2020 | 10.02.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

Form PCT/ISA/210 (patent family annex) (January 2015)

| INTERNATIONAL SEARCH REPORT<br>Information on patent family members | | International application No.<br>PCT/JP2019/046332 | |
|---|---|---|---|
| Patent Documents referred to<br>in the Report | Publication Date | Patent Family | Publication Date |
| JP 2016-168625 A | 23.09.2016 | US 2018/0040533 A1<br>paragraphs [0049]-<br>[0064], [0098]-[0105],<br>fig. 1, 5<br>WO 2016/143631 A1<br>EP 3269491 A1<br>CN 107427954 A<br>KR 10-2017-0126878 A | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018222347 A
- JP 3171234 B
- JP 2014160799 A
- JP 2014099596 A
- JP 2016208010 A